(19) Europäisches Patentamt / European Patent Office / Office européen des brevets

(11) **EP 2 528 082 A2**

(12) # EUROPEAN PATENT APPLICATION

(43) Date of publication:
**28.11.2012 Bulletin 2012/48**

(51) Int Cl.:
*H01J 37/32* (2006.01)

(21) Application number: **12175744.7**

(22) Date of filing: **10.02.2009**

(84) Designated Contracting States:
**AT BE BG CH CY CZ DE DK EE ES FI FR GB GR HR HU IE IS IT LI LT LU LV MC MK MT NL NO PL PT RO SE SI SK TR**

(30) Priority: **21.02.2008 EP 08151765**
**24.09.2008 EP 08165019**
**10.11.2008 EP 08168741**

(62) Document number(s) of the earlier application(s) in accordance with Art. 76 EPC:
**09713583.4 / 2 245 647**

(71) Applicant: **FUJIFILM Manufacturing Europe B.V.**
**5047 TK Tilburg (NL)**

(72) Inventor: **de Vries, Hindrik Willem**
**5045 CM Tilburg (NL)**

(74) Representative: **Hutter, Jacobus Johannes**
**Nederlandsch Octrooibureau**
**J.W. Frisolaan 13**
**2517 JS  The Hague (NL)**

Remarks:
This application was filed on 10-07-2012 as a divisional application to the application mentioned under INID code 62.

(54) **Plasma treatment apparatus with an atmospheric pressure glow discharge electrode configuration**

(57)　Plasma treatment apparatus for treating a substrate (6, 7) e.g. for deposition of a layer on the substrate (6, 7). Two opposing electrodes (2, 3) and a treatment space (5) are provided. A dielectric barrier (6, 7; 2a, 3a), comprising in operation the substrate, is provided in the treatment space (5) between the at least two opposing electrodes (2, 3) which are connected to a plasma control unit (4). A gap distance (g) is the free distance in the treatment space (5) of a gap between the at least two opposing electrodes (2, 3) in operation. A total dielectric distance (d) is the sum of the dielectric thickness of the dielectric layers (2a, 3a) and the substrate (6, 7). The product of gap distance (g) and total dielectric distance (d) is controlled to a value less than or equal to 1.0 mm$^2$.

## Fig 3

Printed by Jouve, 75001 PARIS (FR)

EP 2 528 082 A2

**Description**

**Field of the invention**

The present invention relates to a plasma treatment apparatus using an atmospheric pressure glow discharge plasma in a treatment space. Furthermore, the present invention relates to a polymeric substrate suitable for use as a substrate in flexible electronic devices, in particular electroluminescent such as organic light emitting display (OLED) devices.

**Prior art**

European patent application EP-A-1 905 512 discloses a method and apparatus for producing a photo catalytic material using a plasma discharge in an oxygen containing gas atmosphere. The independent claims explicitly mention the use of a dielectric barrier discharge in a specific form, i.e. silent discharge or creeping discharge. Such a type of discharge is different from an atmospheric pressure glow discharge. In essence, a higher energy density is provided in the plasma. In paragraph [0020] it is even explicitly stated that the invention as disclosed is excluding atmospheric pressure glow discharge and arc discharge. The gist of this disclosure is that the light energy created in the silent/ creeping discharges aids in accelerating oxidation of the substrate surface (see paragraph [0013]).

The present invention is amongst others applicable to the enveloping and/or supporting substrate of an electronic device comprising a conductive polymer with an electronic device, a photovoltaic cell and/or semi-conductor devices.

Optical glass has been previously used in electronic display applications as substrate because it is able to meet the optical and flatness requirements and has thermal and chemical resistance and good barrier properties. Main disadvantage of the use of glass is related to its weight, inflexibility and fragility. For this reason flexible plastic materials have been proposed as replacement for glass.

Disadvantages of the use of polymeric substrates are their lower chemical resistance and inferior barrier properties. There is no polymeric substrate alone which can meet the requirements of a water vapour transmission rate (WVTR) of lower than $10^{-6}$ g/m$^2$*day and oxygen transmission rate of lower than $10^{-5}$ cc/m$^2$*day which are needed in case of use of these substrates in electronic devices. For this reason atmospheric plasma's are being explored as method in depositing inorganic barriers on polymeric substrates to improve these inferior barrier properties.

One of the draw-backs here is the stability of the atmospheric plasma's. To improve this stability, various solutions have been provided for example those described in US-6774569, EP-A-1383359, EP-A-1547123 and EP-A-1626613. Another drawback is dust formation upon using an atmospheric glow discharge plasma for deposition purposes. For example, U. S. Patent 5,576,076 teaches the deposition of silicon oxide on a substrate using an atmospheric glow discharge plasma in the presence of a silane in which the deposition of silicon oxide tends to be in the form of a powder.

International patent application WO2005049228 describes a process for depositing a coating on a substrate, using tetraalkylorthosilicate and an atmospheric glow discharge plasma, where allegedly dust formation is prevented. In this publication a perforated electrode is used.

Another method to prevent dust formation is to use glow discharge plasma's at low pressure as described for example in Japanese patent application abstract 07-074110.

In the article 'Formation Kinetics and Control of Dust Particles in Capacitively-Coupled Reactive Plasmas' by Y. Watanabe et al., Physica Scripta, Vol. T89, 29-32, 2001, a description is given of a study at reduced pressure of the influence of both the pulse on-time ($t_{on}$) and pulse off-time ($t_{off}$) in capacitively coupled RF discharges (13.56 MHz). It was shown that an increase in $t_{on}$ duration increases the size and volume fraction of clusters, though the most significant increase occurs above pulse on-time of 10 ms and longer.

It is a known fact, that atmospheric pressure glow discharge plasma's used for deposition of a chemical compound or chemical element suffer from dust formation by which formation of a smooth surface cannot be obtained and the used equipment will accumulate the dust in a short period of time resulting in products with worse barrier properties as the roughness of the barrier layer.

Further in the article "Plasma-deposited silicon oxide barrier films on polyethersulfone substrates: temperature and thickness effects" by D.S. Wuu et al., Surface & Coating Technology 197 (2005) 253-259, it is described that roughness increases almost linearly as a function of the barrier layer thickness using a low pressure PECVD reactor.

**Summary of the invention**

The present invention seeks to provide a plasma treatment apparatus for treating a substrate, such as depositing one or more layers of inorganic barrier material on a polymeric substrate, using an atmospheric pressure glow discharge plasma, which has an improved plasma stability. This is especially suited for obtaining film material with excellent barrier properties, such as water vapour transmission rate or oxygen transmission rate and more in particular for obtaining film material with excellent roughness property independent on the barrier layer(s) thickness or amount.

In a first aspect, the present invention relates to a plasma treatment apparatus for treating a substrate, such as deposition of one or more inorganic barrier layers on a substrate, the plasma treatment apparatus comprising at least two opposing electrodes and a treatment space between the at least two opposing electrodes, a dielectric barrier being provided in the treatment space between the at least two opposing electrodes and comprising in operation the substrate, the at least two opposing electrodes being connected to a plasma control unit for generating an atmospheric pressure glow discharge plasma in the treatment space, in which a gap distance is the free distance in the treatment space of a gap between the at least two opposing electrodes in operation, and a total dielectric distance is a dielectric thickness of the dielectric barrier, and in which the plasma control unit is arranged to control the value of the product of gap distance and total dielectric distance to less than or equal to 1.0 mm$^2$.

In a further embodiment, the product of gap distance (g) and total dielectric distance (d) is controlled to a value less than or equal to 0.5 mm$^2$. Even better properties of the treated or deposited substrate are obtained when the product of gap distance (g) and total dielectric distance (d) is controlled to a value of less than or equal to 0.2 mm$^2$, e.g. less than or equal to 0.1mm$^2$.

The plasma treatment apparatus according to the present invention provides an improved plasma stability, resulting from a lower voltage drop across the dielectric barrier of the DBD electrode structure. Furthermore, the DBD electrode structure is easier and more cost-effective to produce. By controlling the product of gap distance and total dielectric distance actively to a value less than 1, 0.5, 0.2 or even 0.1 mm$^2$, and making an adaptation of the gap distance dependent on the actual total dielectric distance (which may vary depending on the type of substrate being processed), the improved stability is obtained.

In a further embodiment, the total dielectric distance (d) is less than or equal to 1mm. Such a thin dielectric distance (by using a thin dielectric layer on the electrodes, a thin substrate to be treated, or a combination of both) again lowers the voltage drop across the dielectric barrier, making it more easy to obtain a stable glow discharge plasma. In an even further embodiment, the gap distance (g) is less than or equal to 1mm, e.g. less than or equal to 0.8mm. Again, this simplifies the structure and operation of the plasma treatment apparatus.

In a further embodiment, one or more of the at least two opposing electrodes is a roll-electrode. The roll-electrode is e.g. implemented as a cylinder shaped electrode, freely rotating or driven to transport a web as a substrate. The electrode radius is more than 1 cm, e.g. more than 50 cm. A small radius would result in a better quality due to less dust formation related to less side effects at the boundaries of the small radius electrodes. In an even further embodiment at least one of the at least two opposing electrodes is a roll-electrode and a further one has a flat configuration (plate electrode). In these embodiments the radius of the roll-electrode may vary between 1 cm and 10 meter.

In a further aspect the present invention relates to a novel smooth polymeric substrate suitably for use in OLED devices having only one inorganic barrier layer of 20 nm thick and higher and said topside of the inorganic barrier stack has a surface roughness $R_a$ lower than 2.0 nm. In even more preferred embodiment the polymeric substrate has one layer inorganic stack of 50 nm thick or higher (i.e. 100, 150, 200, 250, 350, 500, 600, 700, 800, 900, 1000 nm) and said topside of inorganic barrier stack has a surface roughness $R_a$ below 1.8 nm.

**Short description of drawings**

The present invention will be discussed in more detail below, using a number of exemplary embodiments, with reference to the attached drawings, in which

Fig. 1 shows a schematic view of a plasma generation apparatus in which the present invention may be embodied;
Fig. 2a shows a schematic view in more detail of the electrode structure of the plasma generation apparatus of Fig. 1;
Fig. 2b shows a schematic view in more detail of a further embodiment of the electrode structure;
Fig. 2c shows a schematic view in more detail of another further embodiment of the electrode structure;
Fig. 2d shows a schematic view in more detail of another further embodiment of the electrode structure; and
Fig. 3 shows a graph of the relationship between gap distance and dielectric layer thickness for the plasma generation apparatus according to the present invention.

**Detailed description of exemplary embodiments**

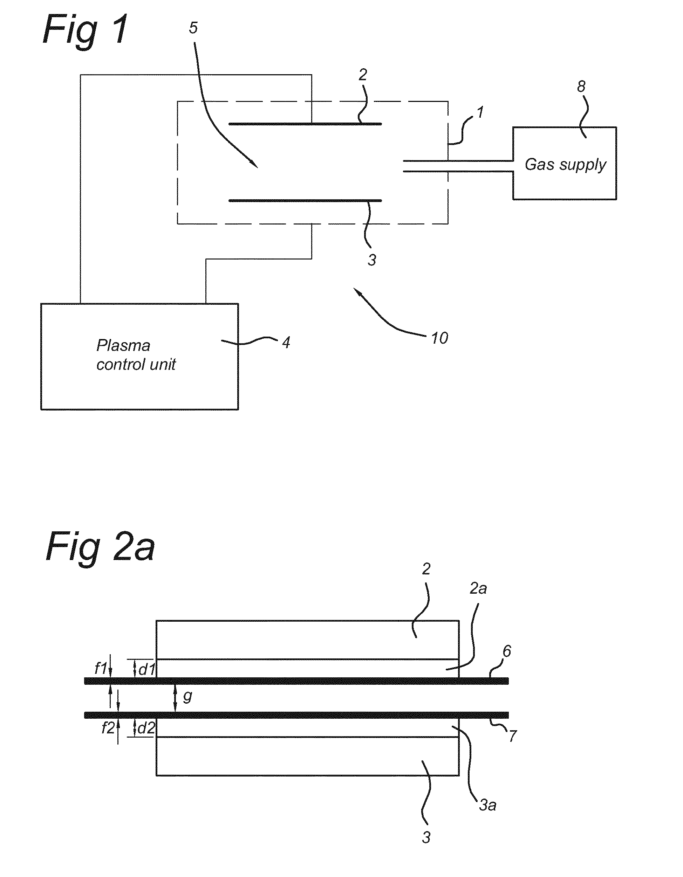

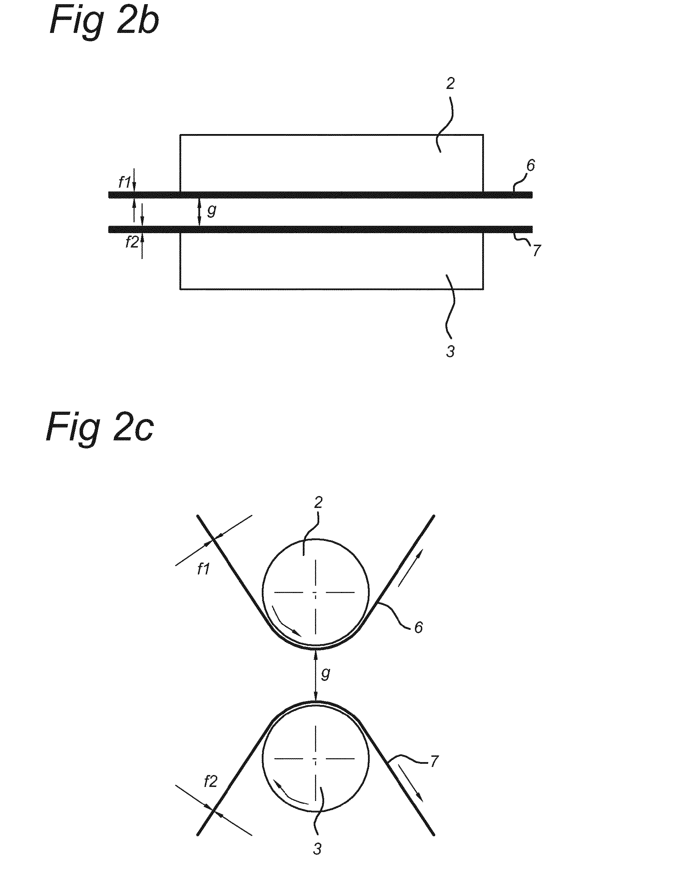

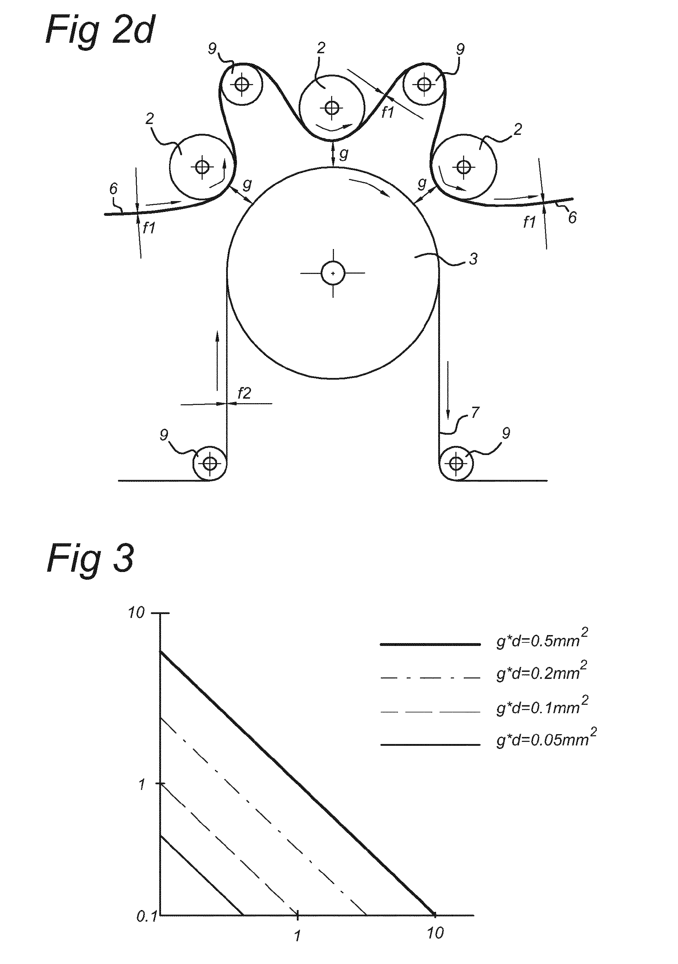

Fig. 1 shows a schematic view of a plasma treatment apparatus 10 in which the present invention is embodied and may be applied. A treatment space 5, which may be a treatment space within an enclosure 1 or a treatment space 5 with an open structure, comprises two opposing electrodes 2, 3. A substrate 6, or two substrates 6, 7 can be treated in the treatment space 5, in the form of flat sheets (stationary treatment) or in the form of moving webs (as shown in Fig 2a , Fig. 2b, Fig. 2c and Fig. 2d). The electrodes 2, 3 are connected to a plasma control unit 4, which inter alia supplies electrical power to the electrodes 2, 3.

Both electrodes 2, 3 may have the same configuration being flat orientated (as seen in the embodiments of Fig. 2a/b) or both being roll-electrodes (as can be seen in the embodiments of Fig. 2c/d). Also different configurations may be applied using a flat and a roll-electrode opposing each other. A roll-electrode 2, 3 is e.g. implemented as a cylinder shaped electrode, mounted to allow rotation in operation e.g. using a mounting shaft or bearings. The roll-electrode 2, 3 may be freely rotating, or may be driven at a certain angular speed, e.g. using well known controller and drive units.

Both electrodes 2, 3 can be provided with a dielectric barrier layer 2a, 3a (see the detailed schematic view in the embodiment of Fig. 2a). The dielectric layer 2a on the first electrode 2 has a thickness of d1 (mm), and the dielectric layer 3a on the second electrode 3 has a thickness of d2 (mm). In operation, the total dielectric distance d of the electrode configuration also includes the thickness of the (one or two) substrates 6, 7 to be treated, indicated by f1 (mm) and f2 (mm) in Fig. 2a. Thus, the total dielectric thickness of the dielectric barrier in the treatment space 5 between the at least two opposing electrodes (2, 3) equals d = d1+f1+f2+d2.

In a further embodiment as shown in Fig. 2b, both d1 and d2 are 0 and the only dielectric material forming the dielectric barrier is the substrate 6, 7 itself. In case of two substrates 6 and 7, the total dielectric thickness in this case is d= f1 + f2.

In still another embodiment both d1 and d2 are 0 and only one substrate 7 is used. In this embodiment the total dielectric thickness equals f2, so d = f2. Also in this embodiment in which electrode 2 is not covered with a dielectric material it is possible to obtain a stable atmospheric glow discharge plasma.

The gap distance g indicates the smallest gap between the electrodes 2, 3 where an atmospheric pressure glow discharge plasma can exist in operation, also called the free inter-electrode space. The total dielectric distance d thus depends on whether one substrate 6 is treated or two substrates 6, 7 simultaneously, and of the thickness and material of the substrates 6, 7.

The dimensions of the electrodes 2, 3, dielectric barrier layers 2a, 3a, and gap g between the electrodes 2, 3, are predetermined in order to generate and sustain a glow discharge plasma at atmospheric pressure in the treatment space 5, in combination with the plasma control unit 4. According to the present invention, the plasma control unit 4 is arranged to set the value of the product of gap distance g and total dielectric distance d to a fixed value. When the relation of the gap distance g and total dielectric distance d complies with the formula

$$g * d \leq 1.0 \ \mathrm{mm}^2$$

it has been surprisingly found that the treated substrate 7 or treated substrates 6 and 7 have excellent barrier properties, such as water vapour transmission rate (WVTR), excellent roughness properties. When depositing layers using the present treatment method, the deposited barrier also has a low carbon concentration. By this new method new smooth products can be prepared with barriers having carbon concentration less than 0.5 wt % and even 0.1 wt %.

Further the surface roughness $R_a$ has been found to be surprisingly not to dependent on the thickness or amount of the deposited inorganic barrier. Even at depositions higher than 100 nm, i.e. up to 1000, 750, 600, 500, 400, 300 or 200 nm the top surface roughness $R_a$ of the inorganic barrier is not more than 20% higher than the starting substrate surface roughness $R_a$ on which the inorganic barrier has been deposited. Further rather constant top roughness values are found independent on the thickness of the inorganic barrier. By this method new smooth composite products can be prepared having one inorganic barriers of 20 nm or higher having very smooth properties showing low surface roughness lower than 2.0 nm i.e. 1.9 or 1.8 or 1.7 nm.

Furthermore, it has been found by experimentation that even better results are obtained when the product of gap distance g and total dielectric distance d is smaller than or equal to 0.5 mm². Further improvements were observed when g * d≤0.2mm², or even when g*d≤0.1 mm², e.g. 0.05 mm².

Furthermore it has been found surprisingly that very good results are found for the treated substrate 6, 7 which have excellent barrier properties when at least one of the two opposing electrodes 2, 3 is a roll-electrode as described above. Good results have been achieved using roll-electrodes 2, 3 with a radius varying between 1 cm and 10 meter. Exemplary embodiments are using at least one roll-electrode 2, 3 with a small radius between 5 cm and 1 meter, e.g. between 10 cm and 50 cm. It is assumed that these results are obtained due to less dust formation related to less side effects at the boundaries of the small radius roll-electrode 2, 3.

Fig. 2c shows a schematic view of an embodiment comprising two roll electrodes 2, 3 of similar dimensions. Fig. 2d shows a schematic view of a further embodiment, in which multiple roll electrodes 2 are being used having a small diameter, and a single roll electrode 3 with a larger diameter. Transfer rollers 9 are being used to guide the substrates 6, 7 against their respective roll electrodes 2, 3. In this embodiment, three treatment spots are provided, where the gap between substrates 6, 7 is held at a distance g. In the embodiments shown in Fig. 2c and 2d two substrates 6, 7 are treated simultaneously.

In order to quantify water vapour transmission rates for barrier films (substrate 7 or substrates 6 and 7 as treated in the above described plasma treatment apparatus 10) two different measurements may be used. A first measurement is done using the Mocon Aquatran which uses a coloumbmetric cell (electrochemical cell) with a minimum detection limit of $5*10^{-4}$ g/m².day. This method provides a more sensitive and accurate permeability evaluation than the permeation measurement by using IR absorption (known to the person skilled in the art). Measurement conditions can be varied from 10-40 °C and also relative humidity usually from 60-90%.

Secondly, to perform even more sensitive permeation measurements a calcium corrosion test was carried out under the conditions of 40°C and 90%RH. Basically, calcium is evaporated on a test substrate and then a glass slide is attached to cover the calcium layer. Then this obtained sample is exposed to 40°C and 90%RH, while monitoring the light absorption from the sputtered calcium layer.

The optical density (OD) of a film is proportional to the thickness so we can calculate the WVTR via the following equation:

$$WVTR = -2A\frac{M[H_2O]}{M[Ca]}\rho_{Ca}\frac{L_{Ca}W_{Ca}}{L_s W_s}\frac{d(OD)}{dt}$$

where A is the scaling factor between calcium thickness and OD, M[H2O], and M[Ca] are the molar masses of water and Ca with values of 18 and 40.1 units respectively, Ca is the density of calcium, $L_{Ca}$ and $W_{Ca}$ are the length and width of the deposited Ca, $L_s$ and $W_s$ are the length and width of the permeation area defined by the interior boundary, d(OD)/dt is the slope of the measured optical absorbance versus time.

In order to quantify the surface roughness an AFM from Veeco Nano Scope IIIa, Veeco Meterology is used from which the Ra was calculated.

The $R_a$ was determined as the arithmetic average of the absolute values of the measured height deviations within an evaluation area of 2 * 2 micron and measured from the mean surface.

The carbon concentration measurements for the deposited barrier layers 6, 7 have been carried out in a Quantera from PHI (Q1). During the measurements the angle between the axis of the analyser and the sample surface was 45°, the information depth is then approximately 6 nm. The measurements have been performed using monochromatic AlKα-radiation in High Power mode (measuring spot 100 μ, scanned over 1400 x 500 μ²).

Alternatively, a plurality of opposing electrodes 2, 3 is provided in the plasma treatment apparatus 10 (e.g. as one of these embodiments shown in Fig. 2d). The electrodes 2, 3 are connected to a power supply, being a part of the plasma control unit 4 as described with reference to Fig.1, which is arranged to provide electrical power to the electrodes for generating the glow discharge plasma under an atmospheric pressure in the treatment space 5. In the treatment space 5, a combination of gasses is introduced from a gas supply device 8, including a pre-cursor. The gas supply device 8 may be provided with storage, supply and mixing components as known to the skilled person. The purpose is to have the precursor decomposed in the treatment space 5 to a chemical compound or chemical element which is deposited on a substrate 6, 7 resulting in an inorganic barrier layer. In general the combination of gases comprises besides the precursor an active gas like for example oxygen and a mixture of inert gases. When using such embodiments in general dust formation is observed after very short deposition times and a smooth dust-free deposition cannot be obtained. In plasmas used for high quality applications (microelectronics, permeation barrier, optical applications) dust formation is a serious concern. For such applications the dust formation can compromise the quality of the coating and the barrier property. At atmospheric pressure dust formation is a common fact, due to the typical large power density of the plasma and large concentrations of reactive molecules. For this reason the industrial use of atmospheric plasmas for coating applications is presently limited to low-end applications such as increasing adhesion. With respect to the mechanism of dust formation in plasma's at atmospheric pressure, it is assumed that the clustering seeds for dust formation are negative and positive ions formed by the dissociation of reactive molecules. In order to prevent dust formation it is necessary to limit the dissociation of molecules by plasma in order to avoid excessive degradation of the molecules or the formation of macro polymers in the plasma. The use of low pressure plasma's is one method to achieve this. At low pressure the ions can not survive more than few milliseconds after the plasma is extinguished and at low pressure the dust particles grow relatively slow (about 10 s) to become of significant size.

Pulsing the power is another standard way to diminish the plasma reactivity by decreasing the average energy transferred to the plasma per unit of time.

In general, in pulsed plasmas the standard method for suppression of dust formation is based on the fast decay of dust coagulation centres during the power off-time of the plasma. This can be regarded as a "natural death" of dust during the plasma off-time. At low pressure plasmas only a short period of power off-time is needed so that the power on-time can be relatively long (in the order of hundreds of ms). The duty cycle, defined as the power on time divided by the sum of the power on and power off time of these pulsing examples is large, typically in the range of 50-98 %. Pulsing the plasma with an off-time of a few milliseconds is enough to interrupt the growth of dust particles and to limit thus the dust formation.

Without being bound to theory the present illustrative description is not based on the "natural death" (decay) of dust coagulation centers but on minimizing their density in plasma so from the stage of Power on time. To the contrary of standard method which is a manipulation of dust formation based on the decay of coagulation centers via adjustment of Power off time this is rather a method based on preventing from the beginning the formation of the coagulation centers.

At atmospheric pressure high duty cycles could not be obtained until now. At atmospheric pressure duty cycles of less than 5% for example 1% were the maximum duty cycles achievable. Pulsing at atmospheric pressure is required to suppress dust formation but has the disadvantage of a slower treatment of a surface. So a low duty cycle is an option only for a limited range of gas mixtures provided that the density of reactive radicals reduces to almost 0 during plasma off-time. It was found that the duty cycle at atmospheric pressure can be increased significantly to values over 5% and even more than 10% for example 15%, or 20%. As stated before in the treatment space 5 a combination of gases is introduced comprising a precursor an active gas for example oxygen and a combination of inert gases. For most of the inert gas compositions a critical oxygen concentration can be identified below which the precursor will not decompose completely anymore, giving a deposition comprising the chemical compound or element to be deposited and the precursor or not completely decomposed precursor molecules. For the system hexamethyldisiloxane (HMDSO) as precursor, oxygen as the active gas and argon as the inert gas for example we found, that below the critical oxygen limit of 1.3% no complete decomposition of the HMDSO could be obtained.

For the system using nitrogen in the inert gas mixture, the activity of the oxygen is increased significantly and the dust formation is suppressed. The efficiency of deposition is increased when using nitrogen compared to the deposition without the use of nitrogen meaning that at the same active gas concentration the deposition is much more efficient and at higher active gas concentrations the formation of dust is suppressed. The use of very low amounts of oxygen gives, from a chemical point of view, homogeneous deposition and duty cycles can be obtained higher than 5% even higher than 20% for example 40%, 50%, 60%, 70%, 80% or even 90% without or with only a very limited amount of dust formation.

In one embodiment besides the precursor the gas composition comprises oxygen and nitrogen. Oxygen can be used for example from 0.01 to 25% of the gas composition and the gas composition can further comprise nitrogen in an amount from 99.99% to 1%. In another embodiment oxygen is used from 0.01-10% and the gas composition can further comprise nitrogen in an amount from 99.99% to 1%. In still another embodiment oxygen is used from 0.01 to 1% and the gas composition can further comprise nitrogen in an amount from 99.99% to 1%. The required amount of oxygen might be even below 0.01 % while still a complete oxidised deposition is obtained. In addition to nitrogen the gas composition may comprise a noble gas like helium, neon or argon. The amount of the noble gas used can range from 1% to as high as 90% of the total gas composition. Even a value of more than 95% for example 99% can be used. In this embodiment the total gas composition including the precursor amount would be oxygen in an amount ranging from 0.01 to 25% and noble gas nitrogen mixture ranging from 99.99% until 75 % with the amounts of nitrogen and noble gas as identified above. When using argon as noble gas, very good results have been obtained.

Embodiments using only nitrogen as the inert gas besides the active gas can also advantageously be used.

In another embodiment the substrate 7 or substrates 6 and 7, are heated during the plasma treatment. By heating the substrate 6, 7 slightly, e.g. by heating electrode 2, 3 slightly, it was surprisingly found that the dust formation was reduced, or even eliminated, while still obtaining good deposition results on the substrate 6, 7. When treating a polymer substrate 6, 7, the temperature of, e.g., the electrode 2, 3 can be raised to a temperature which is higher than normal in inorganic layer deposition on substrate 6, 7 using uniform glow plasma discharges. The temperature may be raised up to the glass transition temperature of the material (e.g. a polymer) of the substrate 6, 7, and in some cases even higher, up to the annealing temperature of the polymer substrate 6, 7. Some commercially available polymer substrates are dimensionally stable above the glass transition temperature, i.e. after heating to a temperature above the glass transition temperature and then cooling down, no change in dimension is observed. In some instances this is even possible almost up to the temperature at which the polymer substrate starts to decompose. E.g. heat stabilized PET (Polyethylene Terephthalate) is available which is dimensionally stable up to 150°C, while the glass transition temperature is 80°C. Also, heat stabilized PEN (PolyEthylene Naphtalate) is available which is dimensionally stable up to more than 200°C, while its glass transition temperature is 120°C.

In order to raise the temperature in treatment space 5 various other embodiments may be used. Examples of such embodiments but are not limited thereto may be found in the not yet published EP07108923.9 from applicant.

Because of the fact, that pulsing reduces the formation of dust the power supply (as part of the plasma control unit 4) may be arranged to provide a periodic electrical signal with an on-time $t_{on}$ and an off-time $t_{off}$, the sum of the on-time and off-time being the period or cycle of the periodic electrical signal.

The power supply can be a power supply providing a wide range of frequencies. For example it can provide a low frequency (f=10-450 kHz) electrical signal during the on-time. It can also provide a high frequency electrical signal for example f = 450kHz - 30MHz. Also other frequencies can be provided like from 450kHz- 1 MHz or from 1 to 20MHz and the like. The on-time may vary from very short, e.g. 20 $\mu$s, to short, e.g. 500 $\mu$s. Because of the beneficial effect of nitrogen also an on time of more than 500μs can be used, for example 1ms. The on-time effectively results in a pulse train having a series of sine wave periods at the operating frequency, with a total duration of the on-time (e.g. 10 to 30 periods of a sine wave) of 0.1 to 0.3 ms.

In another embodiment very short pulses are used in order to prevent the dust formation. Using these very short pulses, the dust formation is even further suppressed, while the deposition rate is kept at a high level because through the use of the gas compositions specified above a duty cycle of more than 1% can be realised.

By using very short on-times of the APG plasma, further charging of the particles is effectively prevented, allowing to control the chemical reactions in the treatment space 5 even more efficiently.

In case of the use of very short pulses the power on-time of the APG plasma is short enough not to cause additional charging of the reactive species, thus allowing a much more effective deposition process. So far a satisfactory explanation of this phenomenon could not be provided.

Pulsing the plasma with an off-time in the order of milliseconds is enough to interrupt the growth of dust particles and to limit thus the dust formation.

For minimizing the density of dust coagulation centers the use of an interval between pulses ($t_{off}$) in the order of the time of residence of the gas in the treatment space 5 of a reactor can also advantageously be used. In this case the time between pulses should be comparable to the residence time of the gas in the discharge space. In the case of argon/oxygen/HMDSO for example there are reactive species with a longer lifetime which need to be flushed before the start of the next pulse. A residence time which is shorter than the cycle time (sum of pulse on-time and pulse off-time) is on the safe side, the residence time should in any case be chosen such, that there is no accumulation of dust coagulation centers. In case of the inventive embodiments using $N_2$, the residence time can be enlarged to values which are higher than the cycle time. Residence times as high as 10 times the cycle times might be used in these embodiments.

The proposed pulsed plasma method as discussed, is based on the suppression of formation of the dust coagulation centers from the initial phase during the power on-time $t_{on}$. Furthermore, it is based on the decay of the dust coagulation centers by adjusting the power off-time ($t_{off}$) and by adjusting the gas composition. The total amount of coagulation centers seem to be determined by the amount of the precursor of the chemical compound or chemical element to be deposited in the plasma gas composition, and the gas mixture used, for example the percentage of oxygen and of course the gas flow as discussed above. In case the precursor amount in the gas mixture is reduced and/or the amount of reactive gas like oxygen, the amount of coagulation centers in the plasma gas will also be reduced. Reducing the precursor amount in the gas composition will off course influence the efficiency of the deposition process. Best results are obtained in general with a precursor concentration from 2 to 500 ppm of the gas composition and for example an oxygen concentration of e.g. 0.01 % of the gas phase, or more, e.g. 2%, but less than 25% for example 10%.

In case of the embodiments using nitrogen, an efficient way of controlling the generation of dust coagulation centers may be accomplished by having the power supply operate at a duty cycles in general from more than 1% or more than 5% for example 10% or 20% and even more than 60%, with short power on-times in the order of 0.05-0.5 ms. The power on-time $t_{on}$ and power off-time $t_{off}$ can be adjusted in order to maintain a large density of reactive radicals and an efficient deposition process but within the limits imposed by the above mentioned conditions.

According to the following illustrative description, ultra short pulses are applied to prevent powder or dust formation in the gas phase at atmospheric pressure in the plasma, hence substantially improving the quality of the deposit on the substrate 6, 7.

Although oxygen as a reactive gas in this illustrative example has a many advantages also other reactive gases might be used like for example hydrogen, carbon dioxide, ammonia, oxides of nitrogen, and the like.

The formation of a glow discharge plasma may be stimulated by controlling the displacement current (dynamic matching) using the plasma control unit 4 connected to the electrodes 2, 3, leading to a uniform activation of the surface of substrate in the treatment space 5. The plasma control unit 4 e.g. comprises a power supply and associated control circuitry as described in the pending international patent application PCT/NL2006/050209, and European patent applications EP-A-1381257, EP-A-1626613 of applicant.

In the present method precursors can be can be selected from (but are not limited to): W(CO)6, Ni(CO)4, Mo (CO)6, Co2(CO)8, Rh4(CO)12, Re2(CO)10, Cr(CO)6, or Ru3(CO)12 , Bis(dimethylamino)dimethylsilane (BDMADMS), Tantalum Ethoxide (Ta($OC_2H_5$)$_5$), Tetra Dimethyl amino Titanium (or TDMAT) $SiH_4$ $CH_4$ , $B_2H_6$ or $BCl_3$ , $WF_6$, $TiCl_4$, GeH4, Ge2H6Si2H6 (GeH3)3SiH ,(GeH3)2SiH2, hexamethyldisiloxane (HMDSO), tetramethyldisiloxane (TMDSO), 1,1,3,3,5,5-hexamethyltrisiloxane, hexamethylcyclotetrasiloxane, octamethylcyclotetrasiloxane, decamethylcyclopentanesiloxane, tetraethoxysilane (TEOS), methyltrimethoxysilane, methyltriethoxysilane, dimethyldimethoxysilane, dimethyldiethoxysilane, trimethylethoxysilane, ethyltrimethoxysilane, ethyltriethoxysilane, n-propyltrimethoxysilane, n-propyltriethoxysilane, n-butyltrimethoxysilane, i-butyltrimethoxysilane, n-hexyltrimethoxysilane, phenyltrimethoxysilane, vinyltrimethoxysilane, vinyltriethoxysilane, aminomethyltrimethylsilane, dimethyldimethylamino silane, dimethylaminotrimethylsilane, allylaminotrimethylsilane, diethylaminodimethylsilane, 1-trimethylsilylpyrrole, 1-trimethylsilylpyrrolidine, isopropylaminomethyltrimethylsilane, diethylaminotrimethylsilane, anilinotrimethylsilane, 2-piperidinoethyltrimethylsilane, 3-butylaminopropyltrimethylsilane, 3-piperidinopropyltrimethylsilane, bis(dimethylamino)methylsilane, 1-trimethylsilylimidazole, bis(ethylamino)dimethylsilane, bis(butylamino)dimethylsilane, 2-aminoethylaminomethyldimethylphenylsilane, 3-(4-methylpiperazinopropyl)trimethylsilane, dimethylphenylpiperazinomethylsilane, butyldimethyl-3-piperazinopropylsilane, dianilinodimethylsilane, bis(dimethylamino)diphenylsilane, 1,1,3,3-tetramethyldisilazane, 1,3-bis(chloromethyl)-1,1,3,3-tetramethyldisilazane, hexamethyldisilazane, 1,3-divinyl-1,1,3,3-tetramethyldisilazane, dibutyltin diacetate, aluminum isopropoxide, tris(2,4-pentadionato)aluminum, dibutyldiethoxytin, butyltin tris(2,4-pentanedionato), tetraethoxytin, methyltriethoxytin, diethyldiethoxytin, triisopropylethoxytin, ethylethoxytin, methylmethoxytin, isopropylisopropoxytin, tetrabutoxytin, diethoxytin, dimethoxytin, diisopropoxytin, dibutoxytin, dibutyryloxytin, diethyltin, tetrabutyltin, tin bis(2,4-pentanedionato), ethyltin acetoacetonato, ethoxytin (2,4-pentanedionato), dimethyltin (2,4-pentanedionato), diacetomethylacetatotin, diacetoxytin, dibutoxydiacetoxytin, diacetoxytin diacetoacetonato, tin hydride, tin dichloride, tin tetrachloride, triethoxytitanium, trimethoxytitanium, triisopropoxytitanium, tributoxytitanium, tetraethoxytitanium, tetraisopropoxytitanium, methyldimethoxytitanium, ethyltriethoxytitanium, methyltripropoxytitanium, triethyltitanium, triisopropyltitanium, tributyltitanium, tetraethyltitanium, tetraisopropyltitanium, tetrabutyltitanium, tetradimethylaminotitanium, dimethyltitanium di(2,4-pentanedionato), ethyltitanium tri(2,4-pentanedionato), titanium tris(2,4-pentanedionato), titanium tris(acetomethylacetato), triacetoxytitanium, dipropoxypropionyloxytitanium, dibutyryloxytitanium, monotitanium hydride, dititanium hydride, trichlorotitanium, tetrachlorotitanium, tetraethylsilane, tetramethylsilane, tetraisopropylsilane, tetrabutylsilane, tetraisopropoxysilane, diethylsilane di(2,4-pentanedionato), methyltriethoxysilane, ethyltriethoxysilane, silane tetrahydride, disilane hexahydride, tetrachlorosilane, methyltrichlorosilane, diethyldichlorosilane, isopropoxyaluminum, tris(2,4-pentanedionato)nickel, bis(2,4-pentanedionato)manganese, isopropoxyboron, tri-n-butoxyantimony, tri-n-butylantimony, di-n-butylbis(2,4-pentanedionato)tin, di-n-butyldiacetoxytin, di-t-butyldiacetoxytin, tetraisopropoxytin, zinc di(2,4-pentanedionate), and combinations thereof. Furthermore precursors can be used as for example described in EP-A-1351321 or EP-A-1371752. Generally the precursors are used in a concentration of 2-500 ppm e.g. around 50ppm of the total gas composition.

As a rough estimation the electron density is proportional with the power density (averaged over half period). According to our experimental results the product between pulse duration and the plasma power density should be smaller than 5 mJ/cm$^2$ or more preferable the absolute value of the charge density (product of current density and time) generated during the power on pulse is e.g. smaller than 5 microCoulomb/cm$^2$, for example 2 or 1 microCoulomb/cm$^2$.

Until now the dust free deposition of chemical compounds using atmospheric pressure glow discharge plasma's could not be achieved, because of the absence of power supplies which were capable of providing very short pulses. The power supply being used has the possibility to generate ultra short pulse trains from 20 ms up to 500 ms. It has been found that dust forming may be prevented when the on-time ton is shorter than the time necessary for forming charged particles in the treatment space, e.g. less than 0.5 ms, or even less than 0.3 ms. Using this power supply, voltage pulse trains may in fact be formed of a series of sine waves having a total duration time (pulse on-time) of 20-500 microseconds. In total the pulse train contains typically 10 to 30 periods of such sine waves. The duty cycle of the power supply (the ratio between the on-time ($t_{on}$) and the sum of the on-time ($t_{on}$) and off-time ($t_{off}$) may vary from 1 to 60%, e.g. between 10 and 20%.

In one embodiment the plasma treatment apparatus, including the stabilized circuit, short pulses and the presence of nitrogen in the gas composition, can provide for deposition rates of more than 1 nm/s e.g. 5 nm/s or even 10nm/s.

In another embodiment the plasma treatment apparatus including the stabilized circuit, the short pulses and the presence of nitrogen in the gas composition is used to apply multiple layers of material by having multiple passes of the substrate through the treatment space, or by having treatment spaces placed in line with each other. In this last embodiment layers of different composition can be applied over each other in a very efficient way, having a thickness of each layer of 1 nm or more.

The substrates 6, 7 used in this illustrative description have a thickness f1, f2 smaller than the gap distance g between the at least two opposing electrodes 2, 3 and may range from 20μm to 800 μm, for example 50μm or 100 μm or 200 μm and can be selected from: SiO$_2$ wafers, glasses ceramics, plastics and the like. By this method and apparatus layers of a chemical compound or chemical element can be deposited on substrates having a relatively low Tg, meaning that also common plastics, like polyethylene (PE), polypropylene (PP), Triacetylcellulose, PEN, PET, polycarbonate (PC) and the like can be provided with a deposition layer. Other substrates 6, 7 which can be chosen are for example UV stable polymer films such as ETFE or PTFE (from the group of fluorinated polymers) or silicone polymer foils. These polymers may even be reinforced by glass fibre to improve impact resistance.

Further the roughness parameter R$_a$ of the (untreated) substrates 6, 7 is not important but preferred ones have a surface roughness R$_a$ in the range of 0.1 to 10 nm. Even more preferred the surface roughness R$_a$ of substrates 6, 7 is in the range from 0.2 to 2.

The substrates provided with the deposition according to the present invention can be used in a wide range of applications like wafer manufacturing, they can be used as barrier for plastics or applications where a conductive layer on an isolator is required and the like. The present invention embodiments can be used advantageously for producing substrates having properties suitable for applications in e.g. OLED devices, or more general for substrates in the form of films or foils which are usable for protecting against deterioration by water and/or oxygen and having smooth properties e.g. barrier films in the field of flexible PV-cells.

EXAMPLES

Several substrates 6, 7 (17.8 cm width and thickness 300, 100 and 50 $\mu$m) have been treated using an excitation frequency of 130 kHz and a 500 microseconds pulse on-time with a 80% duty cycle with a heat controlled electrodes 2, 3 at an electrode surface temperature of 70 °C. The gas composition in the treatment space 5 comprised a mixture of nitrogen and 5% $O_2$, and HMDSO (600mg/hr).

Roll- electrode 3 (with radius 1,5 meter) and a roll-electrode 2 (with a radius of 5 cm) and flat electrodes 2, 3 were used without and with additional dielectric layer 2a, 3a. The substrates 6 and 7 served in part of the experiments as the dielectric barriers. By using substrates 6 and 7 with and without additional dielectric layers 2a,3a the total dielectric thickness could be varied within the desired range, so the total dielectric thickness d could be varied.

Table 1 lists a number of comparative examples and inventive examples. The deposited $SiO_2$ barrier amount was varied by adjusting the line speed where the barrier thickness is inverse proportional to the line speed.

TABLE 1

| Substrate | Ra (nm) [substrate] | Deposited Barrier Thickness (nm) | Type [1] | Configuration electrodes 2/3 | g ($\mu$m) | d ($\mu$m) | Product g*d (mm$^2$) | WVTR (g/m$^2$.day) | Ra (nm) [inorganic barrier] | Carbon content [inorganic barrier] (wt%) |
|---|---|---|---|---|---|---|---|---|---|---|
| PEN | 1.6 | 50 | c | F/F[(**)] | 2500 | 800 | 2 | 2.0 | >10 | >10 |
| PEN | 1.6 | 400 | c | F/F | 2500 | 800 | 2 | 2.0 | >10 | |
| PEN | 1.6 | 50 | c | F/F | 2000 | 800 | 1.6 | 2.0 | >10 | |
| PEN | 1.6 | 50 | c | F/F | 1500 | 800 | 1.2 | 2.0 | 5.2 | |
| PEN | 1.6 | 50 | I | F/F | 1200 | 800 | 0.96 | 0.5 | 1.91 | 0.5 |
| PEN | 1.6 | 50 | I | F/F | 500 | 1000 | 0.50 | $6.93 * 10^{-2}$ | 1.81 | 0.2 |
| PEN | 1.6 | 50 | I | F/F | 500 | 100 | 0.05 | $1.41 * 10^{-4}$[(*)] | 1.75 | < 0.1 |
| PEN | 1.6 | 50 | I | R/R[(***)] | 500 | 100 | 0.05 | $1.29 * 10^{-4}$ [(*)] | 1.72 | < 0.1 |
| PEN | 1.6 | 50 | I | F/R[(****)] | 500 | 100 | 0.05 | $1.35 * 10^{-4}$ [(*)] | 1.73 | < 0.1 |
| PEN | 1.6 | 100 | I | F/F | 500 | 100 | 0.05 | - | 1.72 | < 0.1 |
| PEN | 1.6 | 200 | I | F/F | 500 | 100 | 0.05 | - | 1.82 | < 0.1 |
| PEN | 1.6 | 300 | I | F/F | 500 | 100 | 0.05 | - | 1.84 | < 0.1 |
| PEN | 1.6 | 400 | I | F/F | 500 | 100 | 0.05 | - | 1.85 | < 0.1 |
| PC | 0.8 | 400 | I | F/F | 500 | 100 | 0.05 | - | 0.93 | < 0.1 |
| PET | 1.8 | 400 | I | F/F | 500 | 100 | 0.05 | - | 1.93 | < 0.1 |
| PP | 5..3 | 400 | I | F/F | 500 | 100 | 0.05 | - | 6.02 | < 0.1 |

1) Comparative (C) or according to invention (I)
(*)= measured by a calcium corrosion test under the conditions of 40°C/90%RH
(**)= configuration electrode 2 and 3 are flat
(***)= configuration electrode 2 and 3 are roll-electrodes
(****)= configuration electrode 2 is flat and electrode 3 is a roll electrode

It is clear from these data that when the product g * d is lower or equal than 1.0 mm$^2$, good barrier WVTR and Ra properties are realized. The best WVTR an $R_a$ values were reached for the examples where g * d was equal to 0.05 mm$^2$. Also it is clear that when the product g*d is below 0.5 mm$^2$ the Ra of the inorganic barrier on top of the substrate is not more than 20% higher versus the $R_a$ of the substrate independent on the thickness or amount of the deposited barrier. Further it is clear that better results are obtained when the electrode configuration is using at least one roll electrode 3 with a small radius of 5 cm.

**Claims**

1. Plasma treatment apparatus for treating a substrate (6, 7), the plasma treatment apparatus comprising at least two opposing electrodes (2, 3) and a treatment space (5) between the at least two opposing electrodes (2, 3), a dielectric barrier (6, 7; 2a, 3a) being provided in the treatment space (5) between the at least two opposing electrodes (2, 3) and comprising in operation the substrate (6, 7), the at least two opposing electrodes (2, 3) being connected to a plasma control unit (4) for generating an atmospheric pressure glow discharge plasma in the treatment space (5), in which a gap distance (g) is the free distance in the treatment space (5) of a gap between the at least two opposing electrodes (2, 3) in operation, and a total dielectric distance (d) is a dielectric thickness of the dielectric barrier (6, 7; 2a, 3a), and in which the plasma control unit (4) is arranged to control the value of the product of gap distance (g) and total dielectric distance (d) to less than or equal to 1.0 mm$^2$.

2. Plasma treatment apparatus according to claim 1, in which the product of gap distance (g) and total dielectric distance (d) is less than or equal to 0.5 mm$^2$.

3. Plasma treatment apparatus according to claim 1, in which the product of gap distance (g) and total dielectric distance (d) is less than or equal to 0.2 mm$^2$, e.g. less than or equal to 0.1mm$^2$.

4. Plasma treatment apparatus according to any one of claims 1-3, in which the total dielectric distance (d) is less than or equal to 1mm.

5. Plasma treatment apparatus according to any one of claims 1-4, in which the gap distance (g) is less than or equal to 1mm, e.g. less than or equal to 0.8mm.

6. Plasma treatment apparatus according any of claims 1-5 in which one or more of the at least two opposing electrodes (2, 3) is a roll-electrode.

7. Use of a plasma treatment apparatus according to any one of claims 1-5 for depositing a layer of material on a substrate (6, 7) in the treatment space (5).

8. An organic-barrier stack layer comprising an inorganic barrier of 50 nm or more and a top surface inorganic layer having a surface roughness $R_a$ of less than 2.0 nm.

9. An organic-barrier stack layer comprising an inorganic barrier of 50 nm or more and a top surface inorganic layer having a surface roughness $R_a$ of less than 1.8 nm.

10. An organic-barrier stack layer according to claim 16 or 17 having a carbon concentration of less than 0.1 wt%.

**Fig 1**

**Fig 2a**

# Fig 2b

# Fig 2c

## Fig 2d

## Fig 3

g*d=0.5mm$^2$

g*d=0.2mm$^2$

g*d=0.1mm$^2$

g*d=0.05mm$^2$

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- EP 1905512 A
- US 6774569 B
- EP 1383359 A
- EP 1547123 A
- EP 1626613 A
- US 5576076 A
- WO 2005049228 A
- JP 7074110 A
- EP 07108923 A
- NL 2006050209 W
- EP 1381257 A
- EP 1351321 A
- EP 1371752 A

### Non-patent literature cited in the description

- **Y. WATANABE et al.** Formation Kinetics and Control of Dust Particles in Capacitively-Coupled Reactive Plasmas. *Physica Scripta,* 2001, vol. T89, 29-32
- **D.S. WUU et al.** Plasma-deposited silicon oxide barrier films on polyethersulfone substrates: temperature and thickness effects. *Surface & Coating Technology,* 2005, vol. 197, 253-259